Europäisches Patentamt

(19) European Patent Office

Office européen des brevets

(11) EP 0 872 884 A1

(12) EUROPEAN PATENT APPLICATION

(43) Date of publication:
21.10.1998 Bulletin 1998/43

(51) Int. Cl.$^6$: H01L 21/762, H01L 21/20

(21) Application number: 97302531.5

(22) Date of filing: 14.04.1997

(84) Designated Contracting States:
AT BE CH DE DK ES FI FR GB GR IE IT LI LU MC
NL PT SE
Designated Extension States:
AL LT LV RO SI

(71) Applicant: HARRIS CORPORATION
Melbourne, FL 32919 (US)

(72) Inventor: Beasom, James D.
Melbourne Village, Florida 32904 (US)

(74) Representative:
van Berlyn, Ronald Gilbert
23, Centre Heights
London NW3 6JG (GB)

(54) Method and semiconductor device having maximum terminal voltage

(57) A semiconductor island structure with passive side isolation, for reducing corner breakdown where a device conductor crosses the edge of the island. The decrease in the field strength at the island edge between the conductor and the djacent conducting region is by increasing the depth of the insulator beneath the conductor where it crosses the island edge without the necessity tbr increasing the thickness of the layer of insulation applied directly to the surface of the island by the use of a second or higher level interconnect. The decrease in the field strength at the island edge alternatively or in addition be achieved by increasing the thiclmess of the insulator providing lateral isolation without increasing the thickness of the substrate isolation by the use of lateral trench isolation formed independently of the substrate isolation.

Figure 1

**Description**

The present invention relates to a semiconductor device and method of manufacture in which the terminal voltages formed in passively isolated islands be increased by the reduction in corner breakdown.

Corner breakdown is a known mechanism in dielectrically isolated ("DI") island structures and is disclosed in Weston et al "Monolithic High Voltage Gated Diode Array IC", IDEM 82, pp. 86-87, as being due to the electric field resulting from the potential difference between an island interconnect and the substrate immediately adjacent the lateral edge of fl~ island when the substrate is biased to fully deplete the corner region by a remote reverse biased PN junction. This problem may be attacked by increasing the uniform thickness of the dielectric to about 5 microns (a) between the island and the biased substrate and (b) overlying the island surface- The high field which passes through the extreme (i.e., within a few microns) lateral edge or corner of the semiconductor island at the point where the interconnect crosses the island edge may cause the generation of hole electron pairs by avalanche. The collection of such pairs by a remote reverse biased PN junction in the island will thus limit the voltage which can be applied to the PN junction before conduction occurs. However, the corner breakdown problem occurs not only where the conductor crosses the lateral edge of the island, but where the conductor approaches the island edge. In addition, the 5 micron thickness of the dielectric is unacceptable elsewhere in the island, either overlying the island surface or between the island and the substrate. Not only is it rare that the remote bias of a remote PN junction totally depletes the comer region of the island, but the high bias of the substrate required for such depletion exacerbates the corner breakdown problem. Finally, the geometry of the IC may be such that the offending field is between the interconnect and conducting material other than the substrate.

One way to reduce corner breakdown and thus increase maximum terminal voltage, and at the same time to avoid the problems associated with an uniformly thick dielectric, is to increase the thickness of the dielectric only between the conductor and the surface of the island. However, an increase in the thickness of the oxide applied to the surface of the island is undesirable for other reasons such as increased stress and increased thermal resistance. Further, such initial thickness undesirably increases the ultimate thickness of the IC where second or higher level island interconnects are used and additional thicknesses of insulation must be applied for each conducting layer. Finally, an increase in the thickness of the insulation overlying the surface of the island increases the difficulty in making the necessary connections between the conductors and the surface, particularly where small contacts are desired e.g., the size and profile of the etch of the insulator and step coverage or thinning of the conductor metal.

An object of the present invention is to provide an integrated circuit and method of increasing the maximum terminal voltage of a semiconductor device which avoids the problems of uniformly thicker insulation in DI and which is broader in its application to other types of island isolation.

In one aspect, only the thickness of the insulator layer between the conductor and the surface of the island is increased thereby avoiding the problems of thick insulation between the island and the substrate. Further, the thickness may be increased by the use of additional thin insulating layers without the disadvantages associated with a single thick insulating layer. Another way to reduce corner breakdown and thus increase maximum terminal voltage is to increase only the thickness of the dielectric between the side of the island and the adjacent conducting region to thereby avoid the problems associated with a thick surface layer. As indicated above, and where as is common in DI and SOI isolated islands the oxide which provides vertical isolation of the island from the underlying substrate and which provides lateral isolation is deposited in the same step and has the same thickness, an increase in the thickness of the oxide is undesirable because of increased stress and defects and increased thermal resistance; in some instances, necessitating a significant increase in the size of the circuit.

Another object is to provide an integrated circuit and method of increasing the maximum terminal voltage of a semiconductor device by increasing the effective thickness of the insulator layer between the conductor and the adjacent conducting region without the disadvantages associated with a uniformly thick insulator for the island. Further, the thickness of the lateral insulation may be varied around the perimeter of the island to accommodate the location of interconnects and other circuit elements.

The present invention includes a semiconductor device including an island with passive side isolation from a conductive region, an insulated conductor extending over a lateral edge of the island and the conductive region, characterized by increasing maximum terminal voltage by reducing corner breakdown at the portion of the field between the conductor and the adjacent conductive region, in which corner breakdown is reduced by increasing the thickness of the insulation beneath the conductor where the conductor extends over the lateral edge of the island and the adjacent conductive region.

The invention also includes a method of increasing maximum terminal voltage of a semiconductor island passively isolated from an adjacent conductive region comprising the steps of providing an island passively isolated from an adjacent conductive region, covering the surface of the island with a first insulating layer, establishing a contact to a surface area of the island through the first insulating layer, covering at least a portion of the lateral edge of the island with a second insulating layer, and establishing an electrical connection between the contact and a conductor which extends laterally over the edge of the island and the adjacent conductive region and which is vertically spaced from the surface of the island and the adjacent conductive region by both the first and the second insulating layers.

The invention will now be described, by way of example, with reference to the accompanying drawings in which:

Figure 1 is a pictorial representation and an elevation of a cross-section of a semiconductor device.
Figure 2 is a pictorial representation and an elevation illustrating one embodiment of the modification of Figure; and
Figure 3 is a pictorial representation, and an elevation of a semiconductor device.

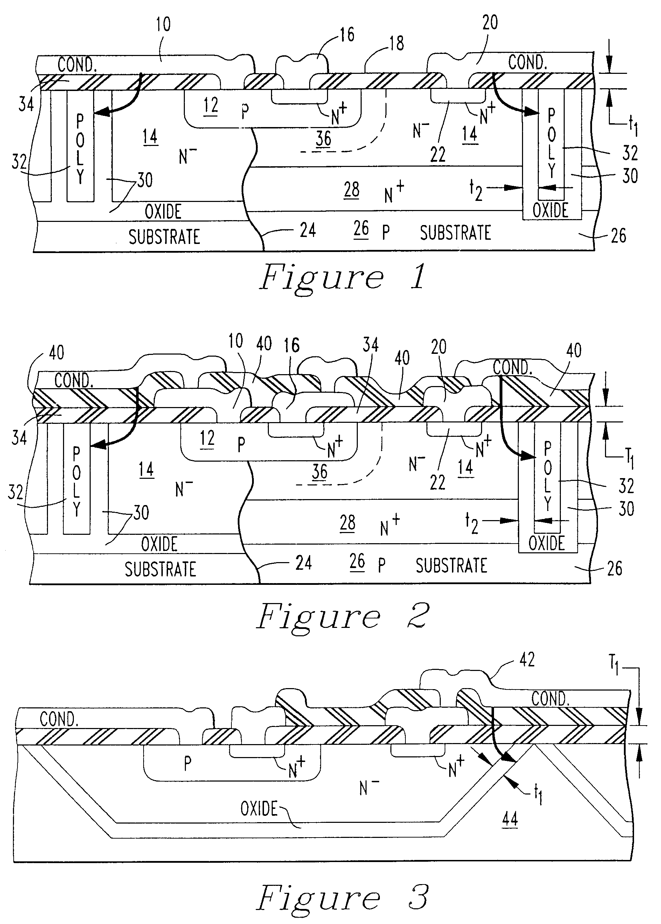

Figure 1 illustrates, a vertical NPN transistor in an island of a semiconductor device. A base conductor 10 is electrically connected to a P doped the well 12 within an island of N- doped semiconductor 14. An emitter conductor 16 is in contact with N + doped semiconductor the well 18 within the P doped base region 12. A collector conductor 20 is in contact with the N-doped collector 14, with the N+ region 22.

Figure 1 shows, the island divided along the line 24 to illustrate different island structures.

The portion of the island to the right of line 24 is a junction isolated or "JI" structure in which the N doped collector 14 is supported on P doped substrate 26 by an N + doped region 28, the PN junction between the regions 26 and 28 providing isolation of the NPN transistor within the island. Laterally, isolation is provided by a conventional trench which comprises a silicon oxide layer 30 with a polysilicon or other conductor 32 filled therein.

To the left of the line 24, the isolation is a form of silicon on insulator or "SOI" and the N- doped collector 14 is supported on a substrate by a silicon oxide insulator 30 integral with the polysilicon filled lateral trench.

The conductors, 10, 16 and 18 are isolated from the upper service of the island by a dielectric layer 34 applied in a conventional process to a thickness $t_1$. As represented by the heavy curved arrows in both the left and right hand sides of the drawing, a field exists between the conductors 10 and 20 and the polysilicon fill 32 of the lateral trench by virtue of the potential difference therebetween.

The field passes through the lateral edges or corners of the collector 14 and, if the field exceeds the critical field, hole-electron pairs are generated by avalanche and will migrate towards the depletion region 36 surrounding the base 12. The hole-electron pairs will be collected by a reverse biased junction and thus, limit the voltage which can be applied across the junction before it breaks down and conducts. In this way, the corner breakdown limits the terminal voltage of the NPN transistor within the island.

The corner breakdown can be approximated by the equation:

$$BV \geq {}^e s \cdot (t_1 + t_2) E_c$$

where BV equals the corner breakdown voltage,
$e_s$ equals the dielectric constant of semiconductor,
$e_i$ equals the dielectric constant of insulator,
$t_1$ equals the thickness of insulator between the conductor and the island,
$t_2$ equals the thickness of the insulator between the island and the adjacent conductive region, and
$E_c$ equals the critical field for breakdown within the semiconductor.

As may be seen from the above equation, the corner breakdown voltage increases directly with the thickness of the insulators between the conductor and the adjacent conducting region. However, as earlier indicated, increased oxide thickness of the layer immediately overlying the island, as the well as increased oxide thickness of the vertical isolation layer, has been found undesirable.

In the present invention, an increase in the thickness of the insulator in the area beneath the conductor adjacent the edge of the island is obtained without an increase in the insulator layer immediately overlying or supporting the island.

Figure 2 shows like elements accorded like numerical designations, an additional insulating layer 40 is provided overlying The first insulating layer 34. As shown on the right hand side of Figure 2, the combined thickness of the insulator between the conductor and the surface of the island has been increased to a minimum thickness of $T_I$. By way of example, in a trench isolated DI process, the thickness of the trench isolation oxide 30, The field oxide 34 and the inter-level oxide layer 40 may each be one micron thick. Using a second level interconnect to cross the island edge as shown in Figure 2 would increase the depth of dielectric by the factor 3/2 and thus produce a 30 increase in the corner breakdown voltage.

A further dielectrically isolated embodiment is illustrated in Figure 3 wherein the field represented by the heavy arrow between the conductor 42 and the substrate 44 passes through two layers of oxide on the surface of the island, with this increase in the surface insulation to a thickness $T_I$ producing a corresponding increase in the breakdown voltage at the corner of the island.

The present invention, The second insulation area need not cover the entire surface of the device, but may be selectively applied in the area beneath the conductor where it approaches the edge of the island.

A semiconductor island structure with passive side isolation, for reducing corner breakdown where a device conductor crosses the edge of the island. The decrease in the field strength at the island edge between the conductor and the adjacent conducting region is by increasing the depth of the insulator beneath the conductor where it crosses the island edge without the necessity tbr increasing the thickness of the layer of insulation applied directly to the surface of the island by the use of a second or higher level interconnect. The decrease in the field strength at the island edge alternatively or in addition be achieved by increasing the thiclmess of the insulator providing lateral isolation without increasing the thickness of the substrate isolation by the use of lateral trench isolation formed independently of the substrate isolation.

**Claims**

1. A semiconductor device including an island with passive side isolation from a conductive region, an insulated conductor extending over a lateral edge of the island and the conductive region, characterized by increasing maximum terminal voltage by reducing corner breakdown at the portion of the field between the conductor and the adjacent conductive region, in which corner breakdown is reduced by increasing the thickness of the insulation beneath the conductor where the conductor extends over the lateral edge of the island and the adjacent conductive region.

2. A semiconductor device comprising an island having a junction and an island contact, passive side isolation, a junction conductor and an island contact conductor, characterized by an increase of the maximum terminal voltage by increasing the depth of the insulation beneath at least one of the conductors where such conductor crosses the island edge.

3. An IC including an island passively isolated from an adjacent conductive region with decreased susceptibility to corner breakdown comprising an island passively isolated laterally from an adjacent conductive region and vertically isolated from a semiconductor substrate, said island having at least one surface contact area, a first dielectric layer overlying the surface of the island except in areas overlying said surface contact areas, a surface contact in electrical contact with said surface contact area and overlying said first dielectric area in the areas immediately adjacent thereto, a second dielectric layer overlying said first dielectric layer and said surface contact except in an contact area of said surface contact, an electrical conductor in electrical contact with the contact area of said surface contact and overlying a portion of said second dielectric area along a path extending laterally from said contact over ale edge of the island and the adjacent conductive region, in which the thickness of the lateral isolation is the same as the thickness of the vertical isolation.

4. An IC as claimed in claim 3 characterized in that said substrate and said conductive region are electrically isolated, in which said lateral isolation includes a polysilicon filled oxide trench.

5. A method as claimed in claims 1or 2 wherein the device is the island is dielectrically isolated and the adjacent conductive region is a second island, and the island is junction isolated with a lateral trench filled with a conductive material.

6. A method as claimed in claim 5 wherein the thickness of the insulation beneath the conductor is increased by providing at least one layer of insulation over the layer of insulation immediately overlying the surface of the island.

7. A method of increasing maximum terminal voltage of a semiconductor island passively isolated from an adjacent conductive region comprising the steps of providing an island passively isolated from an adjacent conductive region, covering the surface of the island with a first insulating layer, establishing a contact to a surface area of the island through the first insulating layer, covering at least a portion of the lateral edge of the island with a second insulating layer, and establishing an electrical connection between the contact and a conductor which extends laterally over the edge of the island and the adjacent conductive region and which is vertically spaced from the surface of the island and the adjacent conductive region by both the first and the second insulating layers.

8. A method of reducing corner, breakdown of a semiconductor island from a field which passes through a corner of an island between a device terminal conductor and an adjacent conducting region by increasing the insulation between the conductor and the adjacent conducting region without increasing the thickness of the insulation layer immediately adjacent the surface of the island, and in which preferably the insulation is increased by the addition of at least one additional insulating layer over the island surface in the area over which the conductor will pass before the conductor is connected to the terminal of the device.

9. A method as claimed in claim 8 wherein the insulation is increased by increasing the thickness of an insulating trench laterally defining the island in the area over which the conductor will pass before the conductor is connected to the terminal of the device, and the trench laterally defining the island is an insulator filled with a conducting material and wherein the insulation is increased by increasing the width of the insulation of the trench between the island and the conducting material.

10. A method of increasing the maximum terminal voltage of a semiconductor device having a junction and an island contact where the device is within a semiconductor island passively isolated from an adjacent conductive region and where the contact conductor passes over the edge of the island, by reducing the field in the island between the conductor and the adjacent conductive region, in which the passive isolation is provided by an oxide trench and wherein the adjacent conductive region is provided by polysilicon within the trench, with the isolation provided by a DI substrate, or the isolation is provided by a SOI substrate.

Figure 1

Figure 2

Figure 3

## EUROPEAN SEARCH REPORT

European Patent Office

**Application Number**

EP 97 30 2531

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO 94 25985 A (HARRIS CORP) 10 November 1994 <br> * the whole document * <br> --- | 1-10 | H01L21/762 <br> H01L21/763 |
| X | PATENT ABSTRACTS OF JAPAN <br> vol. 018, no. 035 (E-1494), 19 January 1994 <br> & JP 05 267442 A (HITACHI LTD), 15 October 1993, <br> * abstract * <br> --- | 1,2 | |
| X | PATENT ABSTRACTS OF JAPAN <br> vol. 018, no. 577 (E-1625), 4 November 1994 <br> & JP 06 216233 A (MATSUSHITA ELECTRIC WORKS LTD), 5 August 1994, <br> * abstract * <br> --- | 1 | |
| X | PATENT ABSTRACTS OF JAPAN <br> vol. 095, no. 010, 30 November 1995 <br> & JP 07 176614 A (TOSHIBA CORP), 14 July 1995, <br> * abstract * | 1,8 | |
| A | --- | 3,7 | |
| A | US 5 387 540 A (POON STEPHEN S ET AL) 7 February 1995 <br> * abstract; figure 9 * <br> * column 1, line 30 - line 61 * <br> * column 3, line 1 - line 8 * <br> * column 3, line 56 - column 4, line 27 * <br> ----- | 1,3-6, 8-10 | |

**TECHNICAL FIELDS SEARCHED (Int.Cl.6)**

H01L

The present search report has been drawn up for all claims

| Place of search | Date of completion of the search | Examiner |
|---|---|---|
| THE HAGUE | 11 September 1997 | Wirner, C |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

                            
& : member of the same patent family, corresponding
document

EPO FORM 1503 03.82 (P04C01)